(19) Europäisches Patentamt
European Patent Office
Office européen des brevets

(11) EP 2 464 008 A1

(12) EUROPEAN PATENT APPLICATION

(43) Date of publication:
13.06.2012 Bulletin 2012/24

(51) Int Cl.:
*H03K 17/96* (2006.01)

(21) Application number: 10194178.9

(22) Date of filing: 08.12.2010

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(71) Applicant: Fujitsu Semiconductor Limited
Kohoku-ku, Yokohama-shi
Kanagawa 222-0033 (JP)

(72) Inventors:
• Harders, Christian
63225 Langen (DE)
• Fronauer, Wolf
63225 Langen (DE)

• Cheng, Shaoyun
63225 Langen (DE)
• Vogel, Markus
63225 Langen (DE)
• Fischer, Dirk
63225 Langen (DE)

(74) Representative: Lewin, David Nicholas
Haseltine Lake LLP
Lincoln House, 5th Floor
300 High Holborn
London WC1V 7JH (GB)

Remarks:
Amended claims in accordance with Rule 137(2)
EPC.

(54) **Sampling circuitry**

(57) Integrated circuitry, comprising: a sampling terminal for connecting the integrated circuitry to an external capacitance; sampling means operatively connected to the terminal to take samples, each sample having a sample value; and control means configured, whilst said external capacitance is connected to the sampling terminal, to: internally connect the sampling terminal, or another terminal of the integrated circuitry to which the external capacitance is also connected, to a given voltage-potential source to effect a change in charge stored on the external capacitance, the given voltage-potential source being available within the integrated circuitry when it is in use; cause the sampling means to take a plurality of samples over a period whilst that external capacitance charges or discharges following and/or during said change in charge; and judge whether an event has occurred in dependence upon the plurality of samples.

FIG. 7

**Description**

The present invention relates to integrated circuitry for use in sampling, and corresponding apparatuses, methods and computer programs. In particular, the present invention relates to sampling techniques useful for detecting capacitance changes.

Such integrated circuitry may be referred to as sampling circuitry, may be implemented as a microcontroller, and may be employed to form apparatus for use in capacitive touch sensing applications.

A microcontroller may be considered to be a type of integrated circuit, and be described as a small computer implemented on a single integrated circuit (or on a set of interconnected integrated circuits - such a set of integrated circuits may be referred to as integrated circuitry). Such a small computer may contain a processor core, memory, and programmable I/O (input/output) peripherals. Program memory may be included "on chip", as well as an amount of RAM (random-access memory). Microcontrollers may be used for embedded applications, in contrast to the microprocessors (also, integrated circuitry) used in personal computers or other general purpose applications. Mixed-signal microcontrollers may be provided, for example comprising analogue-to-digital converters (ADCs) and/or digital-to-analogue converters (DACs), integrating into the microcontrollers analogue components needed to interface with non-digital electronic systems.

The technical area of capacitive touch sensing is considered herein merely by way of example. It will be understood that the present invention may be employed in other technical areas (for example, where a property, such as distance, pressure, or humidity, is measured indirectly by way of capacitive sensing, and especially where a change of capacitance is representative of the property to be measured) with similar effect.

By way of general background, a touch sensor may comprise an insulator such as glass, coated with a transparent conductor such as indium tin oxide. As the human body is also a conductor, "touching" the surface of the sensor results in a distortion of the sensor's electrostatic field, measurable as a change in capacitance. It will be understood that the sensor surface need not be directly touched; proximity of a body may also be detected. Often, there will be no galvanic contact between a body such as a finger and an electrode or other conductive surface of a touch sensor.

Different technologies may be used to detect the occurrence of the touch, and in some instances also determine the location of the touch. Detected information is then typically sent to a controller for processing.

Various implementations for capacitive touch sensing have been considered. They generally differ from one another in the method of raw data acquisition, capacitance measurement, and data processing, as well as in hardware requirements. Sensing methods and data evaluation methods may be combined in different ways.

Capacitive touch sensing generally differs from pure capacitance measuring in that the absolute capacitance is normally not of real interest. Instead, interest is placed on the change in capacitance caused by the approach of a conductive object such as a finger. The baseline capacitance measured by sensing circuitry in its idle state (without touch) may be referred to as an offset capacitance. Usually, the magnitude of the offset capacitance is much higher than the change of capacitance expected due to a touch, which can call for a high SNR (signal-to-noise ratio) and high resolution in touch sensing.

Different sensing technologies will now briefly be considered.

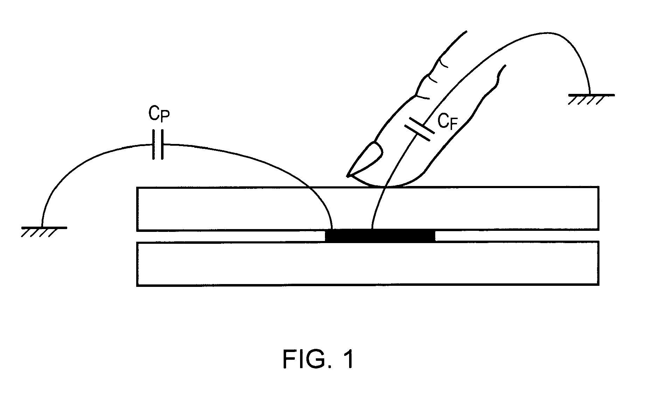

Self-capacitance technologies measure the capacitance of one or more input channels independently. In this regard, reference is made to Figure 1.

The following basic capacitance equation is well understood in the art.

$$C = \xi_r \xi_0 \frac{A}{d}$$

where C is the capacitance;

$\xi_r$ is the relative static permittivity of the material between the two capacitor plates;
$\xi_0$ is the permittivity of free space;
A is the area of overlap of the two plates; and
d is the distance between the two plates.

An important characteristic of this class of touch sensors is the existence of parasitic capacitance, $C_P$, as indicated in Figure 1. Measurements taken will naturally be of the total capacitance of the sensor, $C_{TOT}$, where $C_{TOT} = C_P + C_F$, so the stronger the size of $C_P$ relative to the capacitance due to the touching finger (or other touching body), $C_F$, the harder it may be to see the change in capacitance, $C_F$, due to the touch.

Thus, an approaching conductive object, such as a finger, increases the capacitance $C_{TOT}$ of the electrode, which can be measured. Of course, the parasitic capacitance, $C_P$, may be considered to be the capacitance of the electrode (without the touching finger present), including any capacitance introduced (e.g. input capacitance) by an instrument measuring the capacitance (unless the instrument has been calibrated to account for such introduced capacitance).

Self-capacitance technologies may lead to a simplified layout for button, slider and/or scroll-wheel applications, where often a single layer can be used for the touch electrode layout. Such technologies may, however, have limited multi-touch capability in matrix-layout touchpad/touchscreen applications, due to ambiguous touch recognition for more than a single touch (known as "ghosting").

Mutual-capacitance technologies, in contrast to self-capacitance technologies, measure the capacitive coupling between two or more electrodes. Typically, the electrodes are arranged to form a matrix of driving and sensing electrodes. In some instances, for example in the case of a touchpad or touchscreen, the sensing and driving electrodes are arranged orthogonally to form rows and columns. In such a technology, a signal may be applied to one of the driving or signalling electrodes, and that signal may be sensed (or looked for) at one of the sensing electrodes. Such technologies generally provide a good ability to identify multiple touches by sequential scanning of the driving and sensing electrodes. However, the additional layout effort for many applications, as well as the stronger dependence on cover overlay and PCB material dielectric characteristics, can sometimes prove troublesome.

Different measurement techniques will now briefly be considered.

Many implementations of capacitive touch sensors rely on the measurement of the time an RC (resistor-capacitor) circuit needs to charge or discharge to a certain voltage level.

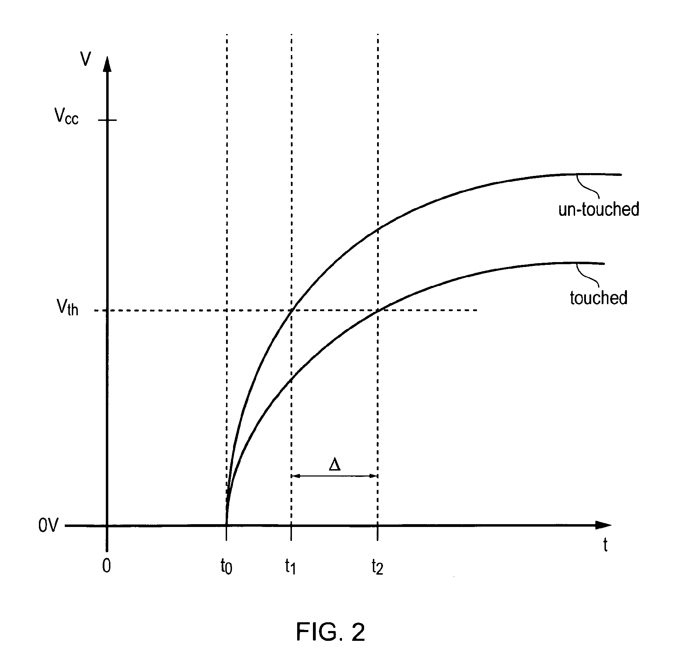

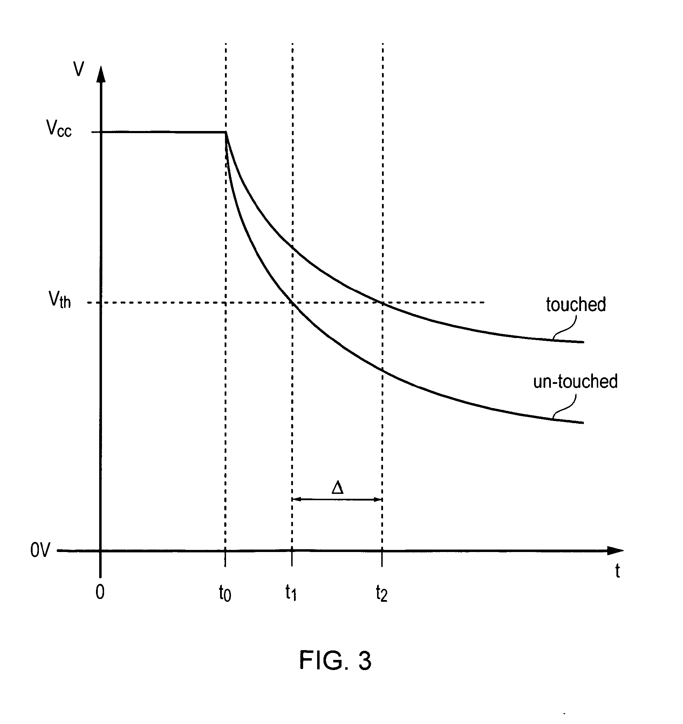

For this time measurement, the unknown capacitance is first discharged (or pre-charged) and then connected via a pull-up (or pull-down) resistor to a known voltage or to a current source/sink at time t0. The pull-up scenario is depicted in Figure 2 and the pull-down scenario is depicted in Figure 3.

The time needed until a certain voltage level (Vth) is reached is measured by the evaluation circuit and then further processed. Because of the proportional relationship between the capacitance and the RC time constant of an RC element ($t \sim R*C$), the capacitance is proportional to the measured rise or fall time.

As mentioned earlier, the absolute amount of capacitance is typically not of real interest for touch applications, but rather the change of capacitance, so that the resistor R usually does not have to be of high precision.

In an un-touched state, the threshold voltage is reached after a time t1, while in a touched state a (longer) time t2 is typically required. The time difference ($\Delta$) between readings taken in the un-touched and touched states corresponds to the amount of capacitance change introduced, e.g. by a finger touch.

A drawback of this measurement methodology is the balance between short measurement time (for high speed) and measurement resolution due to limited measurement timer speed and accuracy, as well as the need for either external resistors or a current source which can be connected to each sensor input (e.g. a pin/terminal of a microcontroller) to be measured.

Methods relying on voltage measurement generally operate in a similar way to the time-measurement methods above, but instead of measuring the time until a certain voltage is reached they measure the voltage reached after a fixed time.

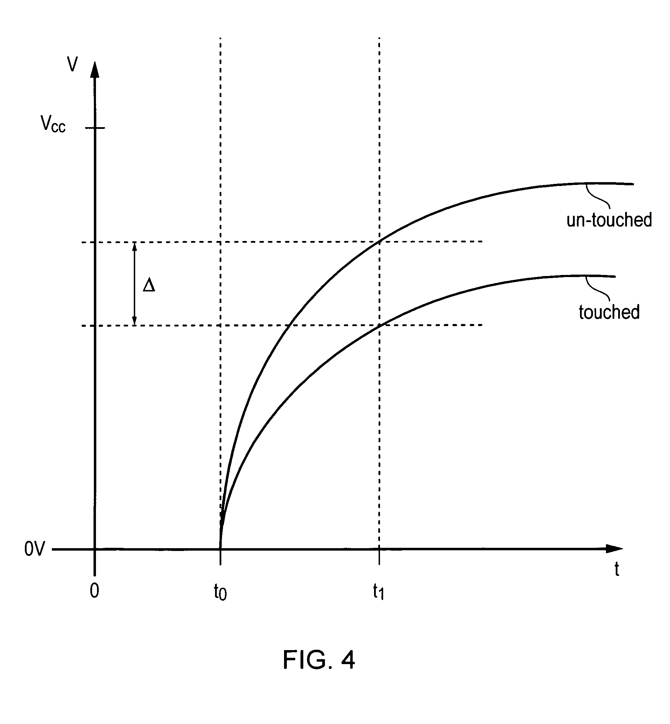

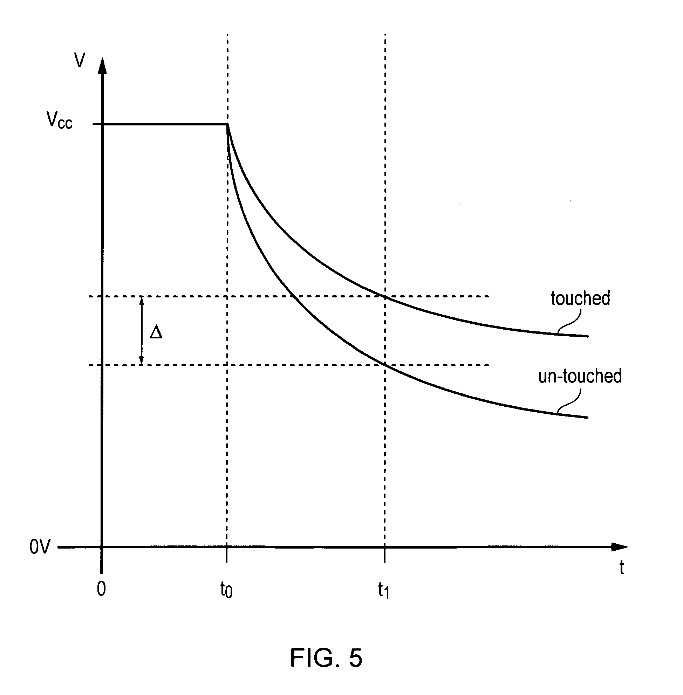

Usually, the unknown capacitance is first discharged (or pre-charged to a known voltage) and then connected via a pull-up (or pull-down) resistor to a known voltage or to a current source/sink at time t0. The pull-up scenario is depicted in Figure 4 and the pull-down scenario is depicted in Figure 5.

After a defined time t1, the voltage over the capacitor is measured. A bigger capacitance (due to a touched, as apposed to un-touched, state) will cause a smaller voltage change after a certain time, as it can store more charge at the same voltage (C=Q/V). The voltage difference (A) between the un-touched and touched states corresponds to the amount of capacitance change introduced, e.g. by a finger touch.

Other techniques have been considered.

In one such technique, a microcontroller is used in accordance with the methodology of Figure 5, and uses GPIO (General Purpose Input/Output) pins or terminals shared with an ADC function to perform the measurement, taking a single sample during the discharge period. Such a technique has been found to have a limited dynamic range and low SNR, resulting in a rather low sensitivity.

Another considered technique uses charge redistribution between the sampling capacitor of the ADC provided in a microcontroller and the capacitance to be measured. In that implementation, the sampling capacitor is internally charged to a defined voltage, and then connected to the (previously discharged) capacitance to be measured. The resulting voltage on the connection point, which is dependent on the value of the two capacitances, is then measured.

Another considered technique uses an "over-sampling" method to decrease the influence of noise in the measurement. However, these methods combine the results of several complete measurement cycles (including charge and discharge of the capacitance to be measured, etc.) to generate one reading, so that the time required for one reading is drastically increased.

Charge-transfer techniques have also been considered, for example as disclosed in US6466036. Some implementations measure the capacitance of an electrode by repeatedly pre-charging it to a certain voltage, and then connecting it to a (usually much bigger) sampling or integration capacitor, causing a charge redistribution to occur. The number of charge transfer cycles is counted until a certain voltage level on the integration capacitor is reached. A drawback of this technique is the necessity of an additional component (the sampling capacitor) and the tolerances this introduces into the system. Furthermore, this method requires additional connections (switches) to control the charge transfer and discharge the sampling/integration capacitor, and the size of the integration capacitor has a strong influence on the detection speed and sensitivity.

As mentioned above, capacitive touch sensing is usually based on measuring the change in capacitance caused by an approaching object like a finger and does not need a precise measurement of the absolute capacitance value. Therefore, to reduce the influence of noise and parasitic capacitance, methods for capacitive touch sensing may use low-pass filtering and offset calibration. The filtering may be applied either to the raw capacitance data, and/or to the active/inactive information after the touch detection. Offset calibration may be implemented by tracking low-speed changes of the measured values, and subtracting them in the capacitance change measurement so that they do not influence the touch threshold. To achieve this, a so-called baseline value may be calculated by the calibration algorithm, and used as a reference for all change monitoring and measurements.

A common overall technique applied in previously-considered systems is that a short-term change in capacitance is compared against a variable threshold, and a touch is signalled if the threshold is exceeded.

The present invention has been devised to address problems identified at least in the previously-considered approaches discussed above. It is desirable to provide integrated circuitry, apparatus, computer programs and methods which have improved SNR performance, improved dynamic range and improved sensitivity. It is also desirable to provide such integrated circuitry which is configured to operate whilst requiring a minimum of external components.

According to an embodiment of a first aspect of the present invention, there is provided integrated circuitry, comprising: a sampling terminal for connecting the integrated circuitry to an external capacitance; sampling means operatively connected to the terminal to take samples, each sample having a sample value; and control means configured, whilst said external capacitance is connected to the sampling terminal, to: internally connect the sampling terminal, or another terminal of the integrated circuitry to which the external capacitance is also connected, to a given voltage-potential source to effect a change in charge stored on the external capacitance, the given voltage-potential source being available within the integrated circuitry when it is in use; cause the sampling means to take a plurality of samples over a period whilst that external capacitance charges or discharges following and/or during said change in charge; and judge whether an event has occurred in dependence upon the plurality of samples.

Such charging or discharging of the external capacitance may be in response to said change in charge.

Such charging or discharging of the external capacitance may be (at least in part, or substantially) caused by or be a result of or be due to the taking of samples by the sampling means.

For example, in the case of discharging of the external capacitance, the taking of samples may draw current from or receive current from the external capacitance into the integrated circuitry. In the case of charging of the external capacitance, the taking of samples may cause an outflow of current from the integrated circuitry to the external capacitance.

By judging whether an event has occurred in dependence upon a plurality of samples per charging or discharging process, an indication of the area under the corresponding charging or discharging curve may be taken into account rather than a single sample.

Such a technique may provide advantages such as improved SNR performance, improved dynamic range and improved sensitivity.

The circuitry may be provided without the external capacitance connected thereto, so that it may be connected thereto later. Alternatively, the circuitry may be provided with the external capacitance already connected thereto.

Each said sample may be indicative of an electrical property present at or experienced at the terminal. For example, the samples may be voltage samples which, individually or collectively, may be indicative of a capacitance value of the external capacitance.

The sampling means may be operable to repeatedly take samples, for example by repeatedly making and breaking a connection to the terminal. The sampling means may be operable to repeatedly take samples in a burst fashion, with a degree of automation in taking one sample after the next.

The taking of a plurality of samples per charge or discharge period may beneficially make use of parasitic elements present in the sampling means or other elements already present in the sampling means (which sampling means may be an ADC circuit), particularly in the case of the external capacitance discharging during sampling.

The sampling means may be operable to take the samples regularly, or substantially regularly. The sampling means may be operable to take the samples over substantially the whole charging or discharging period. Such a charging or discharging period may be considered to be a single charging or discharging of an external capacitance present at the terminal.

The external capacitance may be considered, when connected to the sampling terminal, to be an effective capacitance of the sampling terminal against ground, or between the sampling terminal and a signalling terminal. The external capacitance may charge or discharge via the sampling terminal.

In some embodiments, the control means may be configured, when the external capacitance is connected to the sampling terminal, to, in a first phase, connect the sampling terminal to the given voltage-potential source and, in a second phase following the first phase, disconnect the sampling terminal from the given voltage-potential source and to cause the samples to be taken.

In the case of the external capacitance discharging during sampling, the given voltage-potential source may be a "voltage high" source, for example VDD. In the case of the external capacitance charging during sampling, the given voltage-potential source may be a "voltage low" source, for example GND.

In some embodiments, the integrated circuitry may be configured such that: the other terminal of the integrated circuitry is a signalling terminal; the control means is configured to carry out a signalling process and a sampling process when the external capacitance is connected between the sampling terminal and the signalling terminal; and the control means is configured, in the signalling process, to connect the signalling terminal to the given voltage-potential source as a signal and, in the sampling process, to cause the samples to be taken so as to detect the signal.

Again, in the case of the external capacitance discharging during sampling, the given voltage-potential source may be a "voltage high" source, for example VDD. In the case of the external capacitance charging during sampling, the given voltage-potential source may be a "voltage low" source, for example GND.

In some embodiments, the control means may be configured, in the signalling process, to connect the signalling terminal to a "voltage high" source, for example VDD, and then to a "voltage low" source, for example GND, or vice versa.

In some embodiments, the control means may be configured, in the signalling process, to connect the signalling terminal to a "voltage high" source and the sampling terminal to a "voltage low" source and, in the sampling process, to connect the signalling terminal to the "voltage low" source and to cause the samples to be taken via the sampling terminal.

The sampling means may comprise a sampler resistance and a sampler capacitance arranged such that, when the sampling means is taking a sample and the external capacitance is present at the sampling terminal, charge stored on the external capacitance is permitted to transfer to the sampler capacitance via the sampler resistance (in the case of the external capacitance discharging during sampling). In the case of the external capacitance charging during sampling, the sampler resistance and sampler capacitance may be arranged such that, when the sampling means is taking a sample and the external capacitance is present at the sampling terminal, charge stored (e.g. actively) on the sampler capacitance (before that sample is taken) is permitted to transfer to the external capacitance via the sampler resistance.

The integrated circuitry may be configured such that, between taking successive samples of the plurality of samples, the sampler capacitance is passively at least partly discharged by way of parasitic and/or leakage currents within the sampling circuitry (in the case of the external capacitance discharging during sampling).

The integrated circuitry may be configured such that, between taking successive samples of the plurality of samples, the sampler capacitance is actively at least partly discharged by connecting it to a given voltage-potential source such as a "voltage low" source which may be a GND source (in the case of the external capacitance discharging during sampling).

The integrated circuitry may be configured such that, between taking successive samples of the plurality of samples, the sampler capacitance is actively at least partly (or fully) charged by connecting it to a given voltage-potential source such as a "voltage high" source which may be a VDD source (in the case of the external capacitance charging during sampling).

The integrated circuitry may be configured, after taking a sample of the plurality of samples, to automatically take the next the sample of the plurality of samples, such that the samples are taken in a burst process.

The sampling means may comprise a buffer and be operable to store the sample values of the plurality of samples in the buffer.

The sampling means may comprise a memory and be configured to transfer the sample values of the plurality of samples to the memory by direct-memory-access transfer.

The control means may be configured to combine the sample values of the plurality of samples to generate a sampling result, and to judge whether the event has occurred in dependence upon the sampling result. The control means may be configured to accumulate or sum the sample values to generate the sampling result.

The integrated circuitry may be configured to obtain a series of the sampling results over time, each from a corresponding plurality of sample values obtained over a corresponding period whilst the external capacitance charges or discharges. The control means may be configured to judge whether the event has occurred in dependence upon the series of sampling results.

The integrated circuitry may comprise a filter configured to filter a signal formed from the sampling results to obtain a filtered signal.

The integrated circuitry may comprise first and second filters each of which is operable to filter the or a signal formed from the sampling results, the second filter having a slower response than the first filter, and the control means may be configured to judge whether the event has occurred in dependence upon signals output from the first and second filters.

The control means may be operable to detect a fault in the sampling circuitry based upon the sampling values and/or sampling results and corresponding information indicative of a fault condition. For example, sampling values and/or sampling results expected during normal operation may differ from those expected when suffering a fault condition.

Such integrated circuitry may comprise a plurality of the sampling terminals, wherein the control means is operable to cause a plurality of samples to be taken for each sampling terminal.

In some embodiments, having such a plurality of terminals, the control means may be configured, in synchronisation with the first phase for a particular one of those terminals, to connect the other terminals to the given voltage-potential source and, in synchronisation with the second phase for the particular terminal, to disconnect the other terminals from the given voltage-potential source and to connect them to another voltage-potential source configured to have an opposite effect on the external capacitances of those other terminals to the effect had on them during the first phase of the particular the terminal.

The given voltage-potential source may be a "voltage high" source, for example VDD and the other voltage-potential source may be a "voltage low" source, for example GND, or vice versa.

By controlling such terminals so that they are synchronised with one another, it may be possible to distinguish between (in the case of touch sensing applications) a touch and a fault condition (a localised fault condition, such as may be caused by water in the vicinity of some terminals but not others).

Such integrated circuitry may be, or be part of, a microcontroller.

According to an embodiment of a second aspect of the present invention, there is provided a microcontroller comprising integrated circuitry according to the aforementioned first aspect of the present invention.

According to an embodiment of a third aspect of the present invention, there is provided apparatus for capacitive touch sensing, comprising: integrated circuitry or a microcontroller according to the aforementioned first or second aspect of the present invention; and a capacitance connected to the sampling terminal as the external capacitance and configured to be touchable by a user of the apparatus.

According to an embodiment of a fourth aspect of the present invention, there is provided a computer program which, when executed on integrated circuitry comprising a sampling terminal for connecting the integrated circuitry to an external capacitance and sampling means operatively connected to the terminal to take samples each having a sample value, causes the integrated circuitry, whilst the external capacitance is connected to the sampling terminal, to: internally connect the sampling terminal, or another terminal of the integrated circuitry to which the external capacitance is also connected, to a given voltage-potential source to effect a change in charge stored on the external capacitance, the given voltage-potential source being available within the integrated circuitry when it is in use; cause the sampling means to take a plurality of samples over a period whilst that external capacitance charges or discharges following and/or during the change in charge; and judge whether an event has occurred in dependence upon the plurality of samples.

According to an embodiment of a fifth aspect of the present invention, there is provided a sampling method which, when carried out on integrated circuitry comprising a sampling terminal for connecting the integrated circuitry to an external capacitance and sampling means operatively connected to the terminal to take samples each having a sample value, causes the integrated circuitry, whilst the external capacitance is connected to the sampling terminal, to: internally connect the sampling terminal, or another terminal of the integrated circuitry to which the external capacitance is also connected, to a given voltage-potential source to effect a change in charge stored on the external capacitance, the given voltage-potential source being available within the integrated circuitry when it is in use; cause the sampling means to take a plurality of samples over a period whilst that external capacitance charges or discharges following and/or during the change in charge; and judge whether an event has occurred in dependence upon the plurality of samples.

It is envisaged that the phrase "integrated circuitry" used herein may for some implementations by replaced with the phrase "sampling circuitry", such that it is not a requirement that the circuitry be integrated circuitry.

For example, in the case of a "self-capacitance" implementation in which the external capacitance discharges during sampling, it may be considered that there is disclosed herein sampling circuitry, which may be integrated circuitry, comprising: a sampling terminal for connecting the circuitry to an external capacitance; sampling means operatively connected to the terminal to take samples, each sample having a sample value; and control means configured, whilst said external capacitance is connected to the sampling terminal, to: internally connect the sampling terminal to a given voltage-potential source to effect a change in charge stored on the external capacitance, the given voltage-potential source being available within the circuitry when it is in use; cause the sampling means to take a plurality of samples over a period whilst that external capacitance discharges following said change in charge; and judge whether an event has occurred in dependence upon the plurality of samples.

Reference will now be made, by way of example only, to the accompanying drawings, of which:

Figure 1, discussed above, presents general background information regarding capacitive touch sensing;

Figures 2 and 3, also discussed above, present voltage-time graphs showing the discharging/charging process in touched and non-touched states, as regards taking time measurements;

Figures 4 and 5, also discussed above, present voltage-time graphs showing the discharging/charging process in touched and non-touched states, as regards taking voltage measurements;

Figure 6 is a schematic diagram of apparatus embodying the present invention;

Figure 7 is a schematic diagram of apparatus embodying the present invention;

Figure 8 is a flowchart of a method which may be performed by the Figure 7 apparatus;

Figure 9 is a voltage-time graph useful for understanding operation of the Figure 7 apparatus;

Figure 10 is a schematic diagram relating to the use of filters;

Figure 11 is a schematic diagram of apparatus embodying the present invention; and

Figure 12 presents is schematic diagrams and signal traces useful for considering the effect of crosstalk and water-effect suppression/recognition, particularly as concerns touch-sensing applications.

Embodiments of the present invention are presented herein as relating to sampling circuitry, or more particularly to integrated circuitry. It will be appreciated that in some embodiments such circuitry may be implemented as a microcontroller. Embodiments of the present invention may employ embedded software and/or (in particular embodiments) dedicated hardware embedded inside an MCU (microcontroller unit) to implement capacitive touch applications, as one example application of the present invention. However, it will be appreciated that some embodiments of the present invention may be implemented by way of a microcontroller having no dedicated hardware externally or internally, beyond the presence of internal ADC circuitry and an external electrode. The present invention may, for example, be advantageously embodied as a microcontroller having suitable code (a computer program) stored therein for controlling operation of the microcontroller.

Embodiments of the present invention are considered to provide substantially increased signal-to-noise ratio (already at the stage of taking raw data, i.e. sampling results), higher sensing resolution, and a higher dynamic range, as compared to previously-considered arrangements. In the context of capacitive touch sensing, 'minimum' embodiments of the present invention require no external components (beyond an external capacitance, corresponding to an external electrode), have little if any reliance on high-precision time measurement, and have low CPU (Central Processing Unit) resource requirements (in the case of microcontroller embodiments), as compared to previously-considered arrangements. Of course, some embodiments might employ additional external components to meet some specific additional requirement.

Some embodiments of the present invention are considered to provide substantially advanced filtering and calibration algorithms as compared to previously-considered arrangements, to increase system stability, versatility, usability and configurability.

Some embodiments disclosed herein, for example relating to capacitive touch sensing, are applicable to almost any microcontroller sharing A/D (analogue-to-digital) converter pins with standard I/O (input-output) functions, and are highly robust against variations between different I/O and analogue cell implementations and variations. Such embodiments do not require external components (beyond an external capacitance, which may be a simple electrode, or in some instances could even be embodied by an actual specially adapted microcontroller pin itself), and use only a single pin (terminal) per capacitive sensing channel. In such an embodiment, only a low-frequency periodic interrupt, e.g. given by a timer, is required to ensure a stable sampling frequency for the data acquisition and filtering.

In the context of a microcontroller or other similar integrated circuit, an I/O terminal may be considered to be connected to a pin for access to the outside world, or may be considered to be the same as such a pin. The terms "terminal" and "pin" may be used interchangeably herein, however it will be appreciated that they could be considered to be separate elements connected together.

It is reiterated that, although some embodiments disclosed herein are presented as relating to capacitive touch sensing, e.g. for use in HMI (human-machine-interface) devices, other embodiments of the present invention may be employed in other technical areas. For example, there may be interest in other technical areas in the measurement of a capacitance value or a change of capacitance.

By way of introduction, a focus of embodiments of the present invention is in looking to the area under (or over) the voltage-time curve of a capacitance (the capacitance to be measured) which is discharging or charging, rather than relying on a single sample or measurement.

That is, embodiments of the present invention judge whether an event (such as a touch, in the case of capacitive touch sensing) has occurred in dependence upon a plurality of samples taken during the discharging or charging process, i.e. over a period whilst a capacitance charges or discharges. If, for example, voltage samples are taken repetitively throughout a particular discharging/charging process (i.e. between a charged status and an uncharged status, or *vice versa)* and then combined (e.g. summed), it will be appreciated that the result of the combination may be indicative of or proportional to the area under the voltage-time curve.

Another focus of embodiments of the present invention is in providing circuitry which may be implemented by way of an existing microcontroller executing code (a program, such as a computer program) in accordance with the present invention, without requiring external components beyond an electrode.

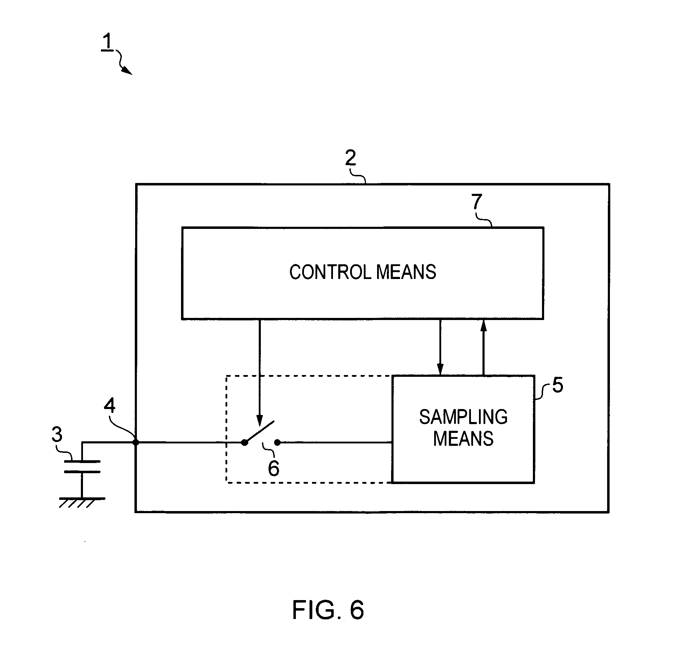

Figure 6 is a schematic diagram of sampling apparatus 1 embodying the present invention.

The sampling apparatus 1 comprises sampling (integrated) circuitry 2, itself embodying the present invention and an external capacitance 3 connected to (present at) a terminal 4 of the sampling circuitry 2.

As shown in Figure 6, external capacitance 3 may be considered to be equivalent to a discrete component connected at one end to the terminal 4 and grounded at its other end. In practical embodiments, external capacitance 3 may be the capacitance associated with an electrode as referenced against ground, i.e. not a discrete component as such.

Sampling circuitry 2 comprises the terminal 4, sampling means 5 connectable (in this embodiment, by way of switching means 6) to the terminal 4, and control means 7. As indicated in Figure 6 by dashed lines, the switching means 6 may be considered to be part of sampling means 5.

In Figure 6, the terminal 4 (sampling terminal) is for connecting the sampling circuitry to other circuitry. The sampling means 5 is operatively connected (in some respects, "connectable" in view of switching means 6) to the terminal 4 to take samples, each sample having a sample value. The control means 7 is configured to repeatedly connect the sampling means 5 to the terminal (by way of switching means 6) so as to cause the sampling means to take a plurality of samples whilst an external capacitance 3 present at the terminal 4 charges or discharges, and to judge whether an event has occurred in dependence upon the plurality of samples.

The connections between the control means 7 and the sampling means 5 and switching means 6 may be for data and/or control signals.

The event may, for example, be that a capacitance value of the external capacitance 3 has changed, for example by at least a predetermined or given amount, for a predetermined or given period of time, and/or with a predetermined or given amount of stability. In the context of capacitive touch sensing, the external capacitance 3 may form part of a touch sensor or sensor electrode, and such a change of capacitance value may be caused by a finger or other body touching the touch sensor or sensor electrode.

Sampling circuitry 2 is integrated circuitry, for example a microcontroller. Terminal 4 may for example be, or be connected to, a GPIO pin of such a microcontroller.

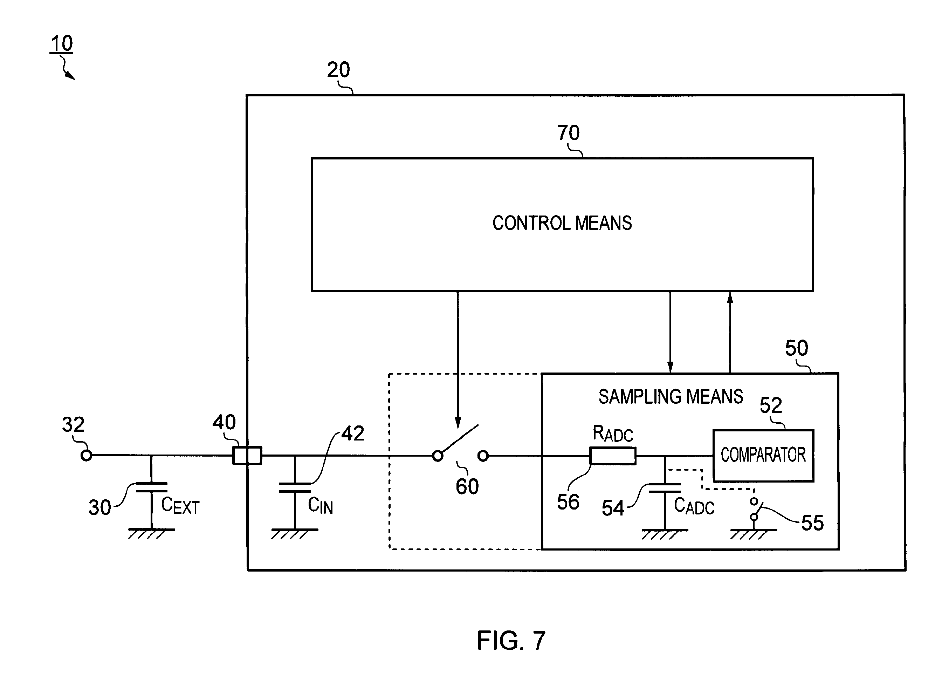

Figure 7 is a schematic diagram of sampling apparatus 10 embodying the present invention.

The sampling apparatus 10 comprises sampling (integrated) circuitry 20, itself embodying the present invention and an external capacitance 30 connected to (present at) a terminal 40 of the sampling circuitry 20. As shown in Figure 7, external capacitance 30 is equivalent to a discrete component connected at one end to the terminal 40 and is grounded at its other end, but may be a capacitance associated with a connected electrode referenced against ground.

Sampling circuitry 20 comprises the terminal 40, sampling means 50 connectable (in this embodiment, by way of switching means 60) to the terminal 40, and control means 70. The sampling circuitry 20, external capacitance 30, terminal 40, sampling means 50, switching means 60, and control means 70 correspond to the sampling circuitry 2, external capacitance 3, terminal 4, sampling means 5, switching means 6, and control means 7, respectively, as shown in Figure 6. Thus, switching means 60 may be considered to be part of the sampling means 50, as indicated in Figure 7 by dashed lines.

In Figure 7, the sampling circuitry may be considered to be a microcontroller (e.g. an MCU, or microcontroller unit). Terminal 40 may be considered to be a GPIO pin of such a microcontroller, and has an effective input capacitance modelled as $C_{IN}$ 42. Input capacitance $C_{IN}$ 42 is equivalent to a discrete component connected internally between terminal 40 and ground supply (GND, or Vee or Vss).

External capacitance 30 represents the capacitance between the terminal 40 (via an electrode 32) and ground. Electrode 32 is connected to terminal 40 and may be considered to be a sensor electrode, in the context of capacitive touch sensing. The capacitance value of external capacitance 30 may change when a finger or other body touches the sensor electrode.

Sampling means 50 comprises a comparator 52, a sampler capacitance 54 and a sampler resistance 56. In one embodiment, sampling means 50 may be an analogue-to-digital converter (ADC). Sampler capacitance 54 and sampler resistance 56 may be considered to be representative of the effective input impedance of the comparator 52 during the sampling process (while switching means 60 is closed) taking into account a resistance of switching means 60. For convenience of understanding, sampler capacitance 54 and sampler resistance 56 are modelled as discrete components in Figure 7. Sampler resistance 56 is connected between the input of the comparator 52 and the switching means 60, via which the sampling means may be connected to the terminal 40. Sampler capacitance 54 is connected between the input of the comparator 52 and ground supply (GND, or Vee or Vss).

Sampler capacitance 54 and sampler resistance 56 may be considered to be or at least partly be "parasitics", which are normally unwanted. For example, sampler resistance 56 may effectively be the resistance of the switching means 60 (which may be implemented as a - non-ideal - FET). It will be appreciated that embodiments of the present invention make use of these parasitics in a beneficial way to measure the external capacitance 30.

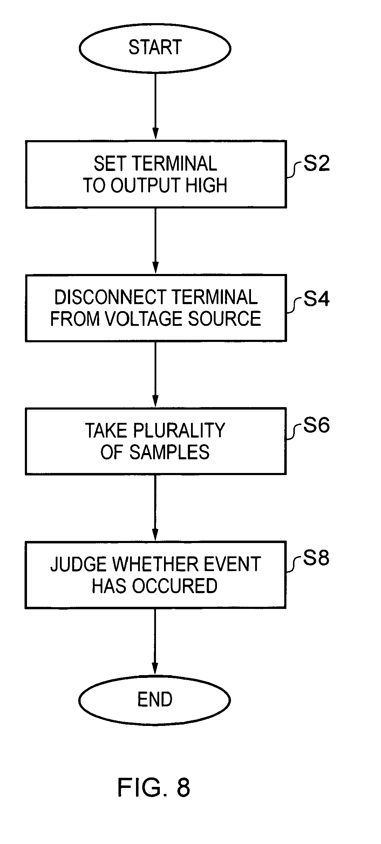

The apparatus of Figure 7 operates in accordance with a method depicted in the flowchart of Figure 8.

In a first step, S2, the external capacitance 30 is pre-charged by connecting it to the voltage supply (Vcc or Vdd) of the microcontroller 20. That is, the terminal 40 (GPIO pin) is set to Output High, which is to say it is internally connected to a given high voltage potential (Vdd, in the case of FET technology) available within the microcontroller 20 when it is in use.

In step S4, the terminal 40 is disconnected from the voltage source. Step S4 may occur, for example, a given amount of time after step S2, to enable the external capacitance 30 to become pre-charged.

In step S6, a plurality of samples are taken by the sampling means 50, by repeatedly connecting the sampling means to the terminal 40 by way of switching means 60. Samples may be taken, for example, for a predetermined amount of time, or until a predetermined number of samples have been taken. The samples may be taken in a burst process. The samples may be taken repeatedly, quickly, frequently and on a regular basis. Step S6 preferably starts immediately after step S4, although in other embodiments there may be a given delay between step S4 and step S6.

Step S6 may be considered itself to constitute a measurement process. The discharge of external capacitance 30 during the measurement process may occur at least partly due to parasitic leakage currents inside the sampling means and the remaining circuitry of the microcontroller 20 (not shown in Figure 7).

A main influence on the discharging process comes from the charge redistribution during every sampling process of the sampling means 50 (i.e. as each sample is taken). During every sampling process, the sampler capacitor 54 is connected to the terminal 40 (analogue input) through the switching means 60 (sampling switch) having sampler resistance 56. Therefore, charge redistribution occurs in that every measurement (taking of a sample) discharges the external capacitance 30 by a certain (small) amount dependant on the ratio of the involved capacitances 30, 42, 54, their instantaneous voltage levels, the resistance 56, and the time that the sampling switch is closed.

After being disconnected from the terminal, i.e. between the taking of samples, sampler capacitance 54 is discharged either by actively connecting it to internal ground supply (GND) or simply by internal currents, e.g. during the comparison period of the comparator 52, or by other parasitic currents. An optional switching means 55 is shown in Figure 7 connected between the sampler capacitance 54 and internal ground supply (GND), and could be used to actively discharge that capacitance between the taking of samples.

Based on Figure 7, it will be appreciated that the samples taken by comparator 52 may be voltage samples of a voltage present at the input to the comparator 52 at the time the sample is taken. The comparator 52 may output sample values (e.g. digital values) indicative of such voltage samples. Of course, it will be understood that comparator 52 may be part of a larger circuit part, such as an ADC. Typically, the comparator itself will be part of a successive approximation block of the ADC, for example having a SAR (successive approximation register). The successive approximation block as a whole may be used to generate actual sample values, and the comparator 52 is shown without other such circuitry in Figure 7 merely for simplicity.

In step S8 it is judged whether a predetermined event has occurred, which in the context of capacitive touch sensing corresponds to the touching of the sensor electrode 32 by a finger or other body.

Step S6 will now be considered further.

As stated above, embodiments of the present invention judge whether an event (such as a touch, in the case of capacitive touch sensing) has occurred in dependence upon a plurality of samples taken during the discharging or charging process. Thus, in the present embodiment a single raw data value (a sampling result) is obtained from or consists of a plurality of single samples (sample values).

Each sampling event (the taking of a single sample of the plurality of samples as the external capacitance 30 discharges) leads to a further discharge of the capacitance to be measured (external capacitance 30), and thus the taking of the plurality of samples can be advantageously used to accelerate the measurement process.

This "acceleration" will be considered further.

When using an ADC (c.f. sampling means 50), it is typically intended that the influence of the measurement circuit on the signal source (and thereby on the measurement result) be kept as small as possible. That is, typically the parasitic influences such as input leakage current, the size of the sampling capacitor, etc., are minimised. As an example, with a big sampling capacitor, measuring a voltage from a high-impedance source will take a longer time than with a smaller capacitor, because of the higher charge amount required to charge the (big) sampling capacitor to the input voltage. Since the resistance of the high-impedance source limits the in-flow of current, the amount of current flow and with it the charging speed is limited. Also, input leakage current into the ADC will cause a (usually undesired) voltage drop on the high-impedance voltage source.

In contrast, in the Figure 7 apparatus the influence of the (sampling means 50) ADC parasitics is increased intentionally by sampling the input several times without re-initialization of the external capacitance 30, so that the external capacitance 30 is intentionally influenced (discharged) by the current flow into the ADC due to the charge re-distribution and parasitic currents inside the ADC.

As an aside, this effect may be appreciated using an oscilloscope; if several microcontroller input channels are switched from Vdd to 'ADC input mode' at the same time, one of them being 'burst sampled' may be seen to discharge faster than the other ones, shortening the time for one measurement acquisition in the context of Figure 7 (assuming the same discharge end voltage for each of the input channels). If the total number of samples is kept identical (by sampling fast enough, e.g. employing a burst/continuous mode), speed is gained through burst sampling without loosing resolution. With an 'ideal' ADC, the discharge speed would be independent of the ADC activity (and would even be zero, if absolutely no parasitic losses were present).

As another point, in case of slow discharge (e.g. taking a single sample at the end of a discharge cycle), the amount of discharge in an "idle" (i.e. non-burst) state might be very small (i.e. the voltage after a certain, acceptable, time may not have fallen too far below Vdd), restricting the dynamic-range/headroom of the system (an even bigger capacitance due to a touch would reduce the amount of discharge even more). This is especially the case if the offset capacitance is big (much bigger than the sampling capacitance), which usually is the case. This problem could be solved by using an external resistor or current sink to discharge the capacitance faster, but at the cost of external components. It will be appreciated that in the Figure 7 apparatus the internal parasitics and burst sampling are intentionally used to achieve a high amount of discharge per plurality of samples.

As yet another point, embodiments of the present invention may have advantages when considering susceptibility to noise, such as RF noise, from external sources.

By way of background, measurement circuits with very high input impedance tend to be susceptible to noise from different sources, such as RF noise from cell phones and other sources. Especially in the case of capacitive touch sensing, many implementations potentially suffer from noise susceptibility due to high input impedance.

In the context of embodiments of the present invention (see for example Figures 6 and 7), since every sample during the acquisition process leads to a current flow into the sampling means 50 (sampling circuit), the average input current flowing into the circuitry is higher compared to circuitry which may be considered to be mainly "idle", e.g. when taking only a single sample per charge or discharge cycle.

In effect, this higher average current may be seen as being caused by a 'virtual impedance' which is considerably lower than the input impedance of the sampling means 50 (sampling circuit), e.g. the input impedance seen at terminal 40, when idle. As an example, when at the beginning of a sample the sampler capacitance 54 is completely discharged, it can be shown that in the first moment after closing the sampling switch (switching means 60) the initial in-rush current - and with it, the effective input impedance - is defined mainly by the sampler resistance 56. Therefore, by the methodology described herein, even though on the first view the electrode 32 being measured is floating (connected only to the high-impedance input of the sampling circuit), a lower virtual 'average' input impedance over the discharge cycle is generated by the repeated sampling process, which in addition to the averaging/integrating behaviour described above strongly increases the robustness against noise, e.g. EMI (electromagnetic interference), caused by cell phones or other noise sources.

Thus, it will be understood that the multiple measurement/burst sampling technique employed in embodiments of the present invention has several benefits, such as (a) discharging the external capacitance in a reasonable time without any external components; (b) increasing the SNR by increasing the dynamic range/ headroom of the system; (c) increased SNR and sensitivity due to the averaging/integrating behaviour; and (d) increased robustness against noise due to a lower virtual 'average' input impedance over the discharge cycle.

Returning to step S6 of Figure 8, regarding the averaging/integrating behaviour mentioned above, for the acquisition of one raw data value (a sampling result), the value of every sample of a particular measurement process (step S6) is accumulated in this embodiment, so that the raw data value (and a signal made up of successive such values) is derived from the area under the discharge curve, not from a single sample per measurement process.

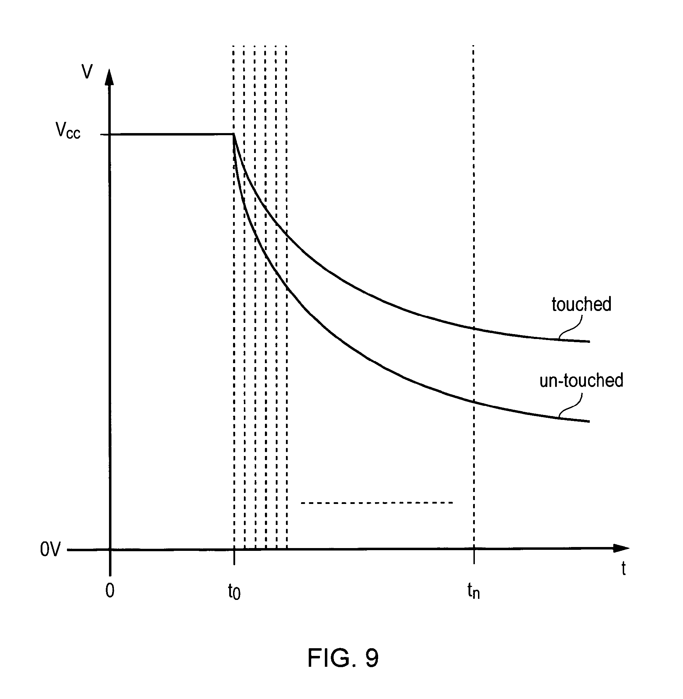

Figure 9 is a graph similar to that of Figure 5, however indicating how embodiments of the present invention differ from the previously-considered approach represented by Figure 5. As represented by the series of vertical dotted lines (not all of them are shown in Figure 9, however as indicated the pattern of vertical dotted lines is understood to be consistent and regular from time to to time $t_n$), a plurality of samples ($0^{th}$ to $n^{th}$) are taken during the discharge process, so that a summed combination (sampling result) of the sample values represents the area under the discharge (or in other embodiments, charge) curve.

It will be appreciated that although a large number of samples (n is large, for example around 20 to 40, or up to 100) per charge or discharge of the capacitance would give a good indication of the area under the curve, a smaller number of samples (for example, between 5 and 10) could also be employed to give a satisfactory indication of the area, with a corresponding lower burden on the circuitry but with a lower SNR and lower sensitivity.

If the method of Figure 8 is carried out on a regular basis, or from time to time, sampling results over time may differ depending on the capacitance value of external capacitance 30. As already mentioned, such a change may be due to a finger or other body touching the electrode 32, in the case of capacitive touch sensing.

By the summing or integrating behaviour understood from Figure 9, the SNR and dynamic range of the system is substantially increased compared to previously-considered measurement methods, including the standard voltage-measurement methods of Figures 4 and 5.

The reasons for the higher SNR may be expressed as follows:

- the wanted signal (A) is amplified by summation over time ($\Delta_{eff} = \sum \Delta_n$), resulting in a higher dynamic range and a better response to small signal changes. That is, a change in external capacitance value manifests itself as a change in area under the discharge curve, which leads to changes in the values of the individual samples of the plurality which may be summed to provide a bigger combined change (representative of the area change). Therefore, the bigger the number of samples in the plurality, the bigger the recorded change for a given capacitance change;
- AC noise is substantially cancelled out of the measurement signal by the integrative behaviour. The bigger the number of samples in the plurality, the higher the resistance against random noise in the measurement (as the baseline of the values can be seen as a constant [offset] with a random AC component [noise]);

• single spikes in the measurement signal have only little impact;

• time jitter of a single sample (e.g. due to interrupt load) has only a small impact and can be minimized by automatic re-start of the sampling means, e.g. an ADC. Such automatic restart may be referred to as "Continuous Mode";

• increased dynamic range/headroom of the system; and

• increased robustness against noise due to a lower virtual 'average' input impedance over the discharge cycle.

In contrast to the previously-considered over-sampling methods discussed above, the methodology of the Figure 7 apparatus (and other embodiments of the present invention) charges the capacitance to be measured only once per reading, and successively discharges it by multiple sampling events (such that each reading is made up of multiple samples), each sampling event leading to a charge redistribution from the capacitance to be measured (external capacitance 30) onto the sampling capacitor (sampler capacitance 54) of the ADC (sampling means 50). Because of the omitted dedicated charge-and discharge phases, a higher number of samples can be taken during the same time, resulting in a higher SNR compared to a single sample and shorter overall acquisition time compared to other over-sampling methods.

As mentioned above, in the apparatus of Figure 7 the sampling circuitry 20 may be considered to be a microcontroller (with other parts of the microcontroller not being depicted in Figure 7). In that instance, the system load (the burden on the control means 70, which may be a processor of the microcontroller) can be held low by arranging for the sampling means 50 (an ADC) to automatically restart the sampling process (to take a further sample) after each sample ("Continuous Mode").

The results of every sample (the sample values) may be held for example in a buffer inside the sampling means 50 (not shown in Figure 7), or may be transferred to a buffer in memory (e.g. of the microcontroller, again not shown in Figure 7) using DMA (direct-memory-access) transfers. In addition to the low system/processor load, the current flow into the sampling means 50 (ADC) due to every sampling process increases the discharge speed of the capacitance to be measured, so that also very high offset capacitances can be handled without hardware changes.

The capability to detect very small changes of the capacitance to be measured (changes of area will be more apparent than changes between two single samples) is useful for capacitive touch sensing systems, as with growing thickness of the dielectric front panel of the touch sensor the change of capacitance caused by an approaching finger can be very small (<<1pF) relative to the basic offset capacitance of the system (often >100pF).

By the methodology described above, a high SNR is achieved in the raw data values (sampling results) themselves, i.e. before any post-processing, and immunity against disturbances can be achieved, so that less intense filtering can be applied during further signal processing.

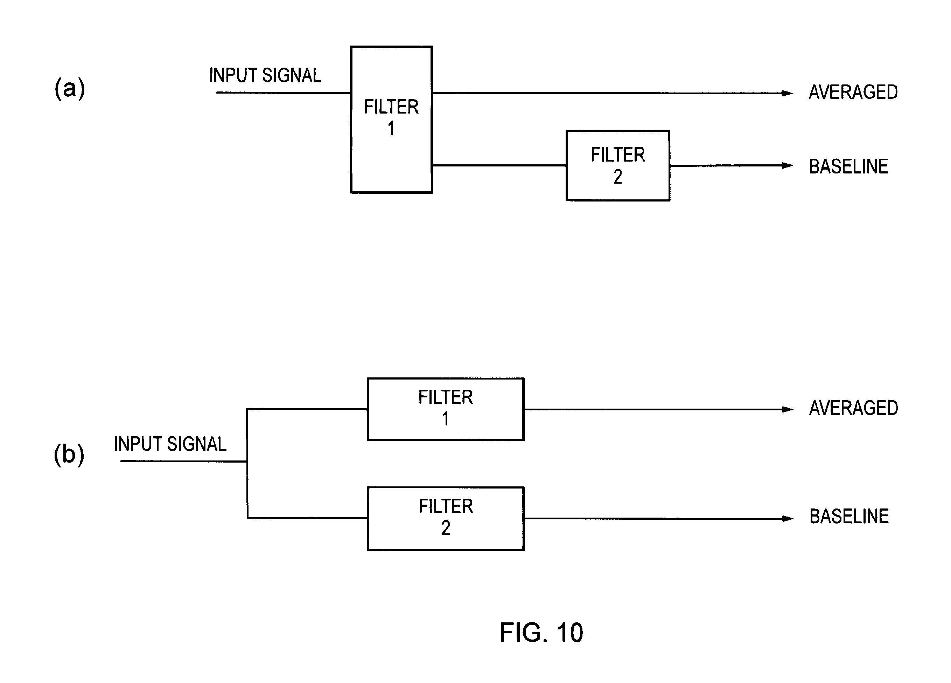

Reference will now be made to Figure 10, which is a schematic diagram representing conceptually how filtering may be employed to make use of a signal comprising a series of raw data values (sampling results).

In the Figure 7 apparatus, each raw-data-acquisition process (shown in Figure 8) consists of the burst sampling as described above, to generate a sampling result. Over time, with repetition of the Figure 8 process, a series of such raw-data-acquisition processes may generate a signal based on or derived from a series of such sampling results. Such a signal (a raw data signal) may be subject to signal processing.

In order to detect a touch, it is desirable to perform offset and drift calibration. Therefore, the raw data signal may be fed into two different low-pass filters (filters 1 and 2), which may be cascaded. Figure 10(a) shows an example of filters 1 and 2 being cascaded, and Figure 10(b) shows an example of filters 1 and 2 being arranged in parallel with one another, with the input signal in both cases being the raw data signal.

In the present embodiment, the first filter (filter 1) has a short-to-medium time constant and mainly averages the raw data signal. The second filter (filter 2) has a slower response than the first, so that it does not follow quick changes as caused by an approaching finger (in the case of capacitive touch sensing).

The second filter's output represents the bottom line (or baseline), which includes the parasitic offset capacitances etc.. As soon as changes of the averaging filter (filter 1) are detected which are above a certain threshold (in the case of capacitive touch sensing, an active touch is detected), the bottom line filter (filter 2) update may be suspended as long as this condition occurs, to avoid calibrating the system to e.g. an approaching finger.

For touch detection (in the case of capacitive touch sensing), the difference between the output of the first and second filters may be evaluated and compared against a threshold value. As soon as the threshold is exceeded, it may be considered that a touch has been detected.

The filter parameters for both filters may be dynamically changed during runtime, and/or may be unsymmetrical, e.g. a quicker response for falling values than for rising ones, to speed up re-calibration after release of a button (i.e. the "un-touching" of a touch sensor).

Incidentally, although the above embodiments have been presented considering a single terminal and present external capacitance, it will be appreciated that in other embodiments there may be a plurality of such terminals each with a present external capacitance. In the case of capacitive touch sensing, such a plurality of external capacitances may correspond to a plurality of sensing electrodes of a complex touch sensor. The above methodology may be applied to each terminal-and-external-capacitance pair. Sampling results from each terminal may be considered on a per terminal basis, or may be considered together.

Referring back to Figure 7, it will be appreciated that sampling circuitry 20 may be considered to be a microcontroller, and such a microcontroller may have several terminals similar to terminal 40 (for example, a set of GPIO pins). With this in mind, it will be understood that embodiments of the present invention may be adapted to detect errors such as short-circuits between sensor pins (terminals) or between a sensor pin (terminal) and ground (GND) or a supply voltage (Vdd).

For example, in the case of a short circuit between two or more input pins (terminals), their sampling results will be close to the theoretical maximum (e.g. the number of samples * 1023, for a 10-bit ADC) or minimum (0), depending on the pin state (0 or 1, i.e. connected to GND or Vdd) of the input pins (terminals) which are not sampled.

For example, in a configuration where all pins are held high during a non-sampling state, the effect of a touch input pin (sampling terminal) connected to another touch input pin (sampling terminal) by a fault condition will have the same effect as connecting it to the supply voltage, i.e. no discharge will be visible during the sampling period, and therefore a value close to the maximum will be seen. Similarly, a pin (terminal) connected to GND by a fault condition will show an instantaneous discharge as soon as the sampling starts, and therefore will show output values close to zero.

In both conditions, the difference between normal operation and information indicative of a fault condition may be detected in the raw data signal, and enable countermeasures such as a safe stop to be taken (for example, by software executed in a microcontroller).

Further embodiments of the present invention are envisaged, in particular where sampling circuitry 20 is a microcontroller.

For example, such a microcontroller may be provided with a range comparator which compares the value of a sample (an ADC sample) against upper and lower thresholds, and determines if the regarded sample is inside or outside a range defined by the threshold values. Also, such a microcontroller may be provided with a pulse detection unit configured to evaluate the output of the range comparator, and may thus be used to detect certain pulse properties.

Such a microcontroller, for example used as part of a capacitive-touch-sensing system, may have a reduced SW (software) overhead as compared to a system not making use of a range comparator and a pulse detection unit.

For example, the threshold values of the range comparator may be set in a way that during non-touch status only a few samples are in the detection range of the range comparator. As soon as the capacitance rises due to a touch event, the signal amplitude rises, leading to more samples inside the detection range. Every sample inside the defined range may be counted by the pulse detection unit, and a signal may be generated as soon as a certain number (of events) is reached.

The range comparator and pulse detection unit may be configured by software running in the microcontroller, but may otherwise operate autonomously without burdening the processor. Such configuration may enable a variable touch threshold to be implemented. The range comparator threshold levels may be used to implement calibration, controlled by the host software.

It will be appreciated that the apparatus of Figures 6 and 7 has been presented with "self-capacitance" technologies in mind, in the case of capacitive touch sensing. However, the present invention may also be applied to mutual-capacitance technologies, in which the capacitive coupling between two or more electrodes is measured.

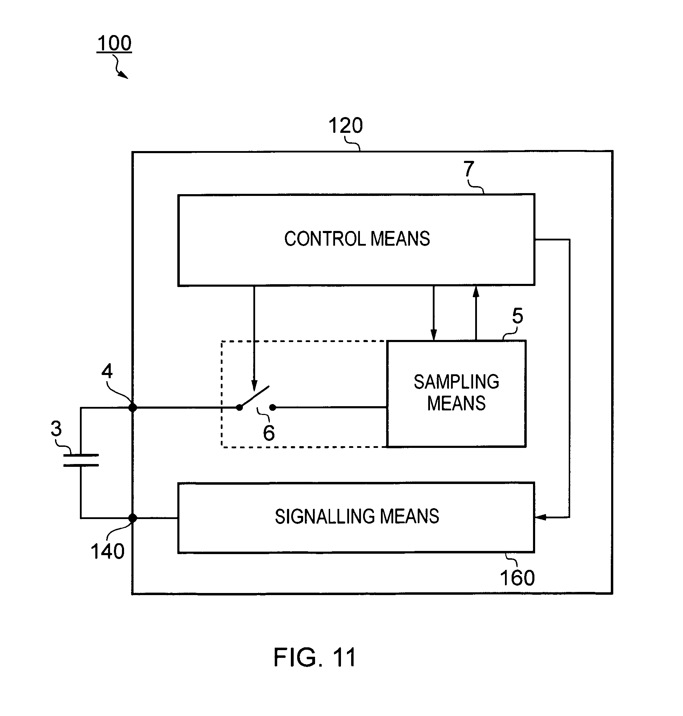

Figure 11 is a schematic diagram of sampling apparatus 100 embodying the present invention.

The sampling apparatus 100 comprises sampling (integrated) circuitry 120, itself embodying the present invention and an external capacitance 3 connected to (present at) a terminal 4 of the sampling circuitry 120.

It will be appreciated that sampling circuitry 120 of Figure 11 is closely similar to sampling circuitry 20 of Figure 6, and like elements are denoted by like reference numerals so that duplicate description may be omitted.

Sampling circuitry 120 comprises signalling means 160 connected to a (signalling) terminal 140. External capacitance 3 is effectively a capacitance measured between terminals 4 and 140, for example between two electrodes respectively connected to those terminals.

In operation, control means 7 may cause the signalling means to output a signal to terminal 140, and correspondingly cause sampling means 5 to take samples at terminal 4 in a similar fashion to that already described above in connection with Figures 6 to 9. It will be appreciated that the capacitance value of external capacitance 3 may vary, for example due to a touch in a touch sensing application, and thus that the signal picked up at terminal 4 may vary dependent on the capacitance value.

Accordingly, it will be appreciated that the teaching presented in relation to Figures 6 to 9 may be applied analogously to Figure 11, such that embodiments of the present invention may relate to mutual-capacitance technologies. For example, it will be readily appreciated that circuitry similar to that depicted in Figure 7 may provided in line with Figure 11.

In some embodiments, terminals 4 and 140 may be multi-use terminals which may be, for example, reconfigured during use. That is, the distribution of sampling means 5 and signalling means 160 to terminals may be configurable, such that in some instances terminal 4 is a signalling terminal connected to a signalling means 160 and in some instances terminal 140 is a sampling terminal connected to a sampling means 5. In the context of touch sensing equipment, an embodiment of the present invention may enable every connection to an external electrode of a touch sensitive area to be configured (dynamically, during use, or on setup) to operate as bidirectional electrode (sampling terminal) for self-capacitance measurement, as a sending electrode (signalling terminal) for mutual-capacitance measurement, and/or as sensing electrode (sampling terminal) for mutual capacitance measurement during operation. That is, the function of the electrodes may be changed over time. It will be appreciated that the non-reliance on external components enables embodiments of the present invention to have such versatility.

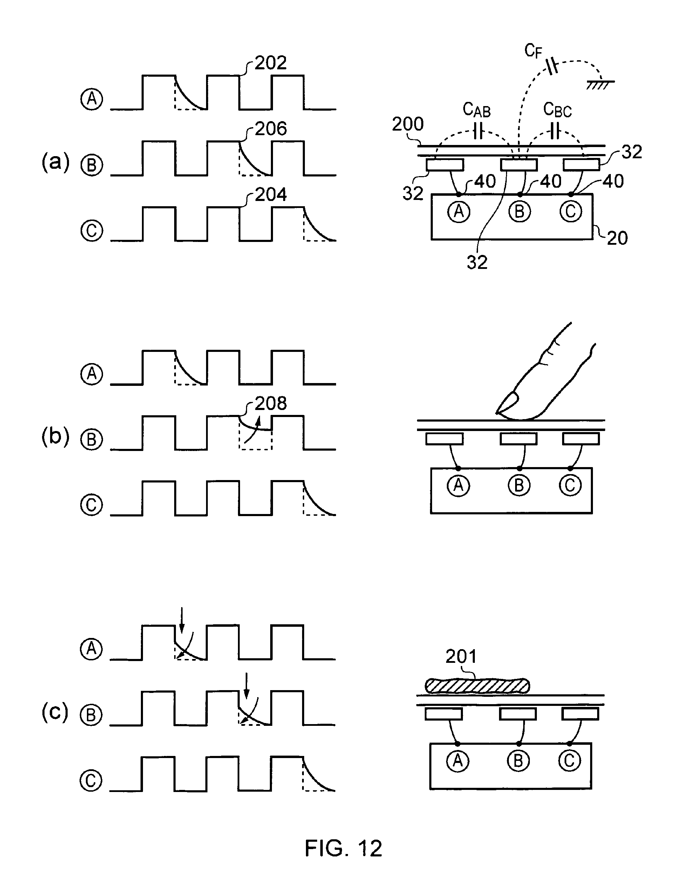

It will be recalled that embodiments of the present invention may have a plurality of terminals each with a present external capacitance, for example in accordance with Figure 7 (self-capacitance) or Figure 11 (mutual capacitance). This possibility will be considered further in conjunction with Figure 12, in the context of crosstalk/cross-coupling, and water-effect suppression/recognition, particularly as concerns touch-sensing applications.

Figure 12(a) corresponds to an embodiment of the present invention (depicted on the right-hand side of the Figure) in line with Figure 7, having three sampling terminals 40 corresponding to three input or sensing channels, labelled A, B, and C.

Accordingly, the Figure 12(a) embodiment has sampling (integrated) circuitry 20 having three sampling terminals 40 each having a corresponding electrode 32. The three electrodes 32 are positioned under a sensor surface 200, which may be made of glass.

Capacitances $C_{AB}$ and $C_{BC}$ depicted in Figure 12(a) represent coupling capacitances experienced between channels A and B, and B and C, respectively. Capacitance $C_F$ represents a capacitance which may be experienced on channel B due to a touching finger, or other body.

The graphs on the left-hand side of Figure 12 (a) correspond to signals which may be received at the channels A, B and C (using the sampling methodology disclosed herein), when no touching finger is present, i.e. when capacitance $C_F = 0$.

Figure 12(b) is the same as Figure 12(a), but represents the scenario in which the touching finger is present, i.e. when capacitance $C_F$ is greater than 0.

Figure 12(c) is the same as Figure 12(a), i.e. capacitance $C_F = 0$, but represents the scenario in which water 201 (or some other substance) is present on the sensor surface 200 between and over channels A and B. In this scenario, capacitance $C_{AB}$ may be considerably larger than capacitance $C_{BC}$. For example, in a 'normal' case (air), most of the electric field between the electrodes/channels goes through the air which has a low dielectric constant (~1), so the overall capacity (capacitance) is low. With, for example, water on the surface, most of the field stays in the water which has a much higher dielectric constant (~80) that increases the capacity (capacitance). In addition, non-deionised water is conductive, which again increases the coupling.

The capacitances depicted in Figure 12(a), and the reference numerals of that Figure, have been omitted from Figures 12(b) and 12(c) for simplicity. However, Figures 12(b) and 12(c) may be readily understood by comparison with Figure 12(a).

Touch-sensing applications are not only influenced by parasitic offset capacitance and high-frequency noise which might be coupled into the sensing electrodes (and thus the sampling terminals). Especially in applications having multiple sensor electrodes in close proximity to each other, the crosstalk (coupling) between the electrodes can influence the sensing performance. The mechanism for such crosstalk is represented in Figures 12(a), (b) and (c) by coupling capacitances $C_{AB}$ and $C_{BC}$.

The measurement to determine the capacitances for the input channels may be done sequentially (e.g. channel A, then B, then C, etc.), accessing one terminal after another by means of some multiplexing. In such a scenario, the remaining input terminals which are not connected to the measurement circuitry (sampling means) during a specific measurement cycle may be connected to GND to reduce possible disturbances.

Even though, on the one hand, the electrodes 32 of the "inactive" channels (e.g. channels A and C) may act as a shield for the electrode 32 of the channel (e.g. channel B) under measurement, and can help reduce the influence of EMI on the measurement being taken (e.g. on channel B), they increase the parasitic capacitance on the sensor (see capacitances $C_{AB}$ and $C_{BC}$). Additionally, in many such implementations, there is the risk that the presence of a conductive object covering multiple electrodes (e.g. water 201) might be erroneously detected as a touch event, because of the increase of capacitance against ground between the electrode being measured and the remaining ones being grounded. For example, in the case of only the active electrode being charged and the remaining ones being grounded, inter-electrode coupling may be seen as electrode coupling against ground.

In embodiments of the present invention, the handling of the "inactive" channels (the remaining terminals) during measurement of a particular channel (a single terminal) can be widely and freely adapted to different requirements. The remaining terminals may be grounded (GND) as described above, connected to a pre-defined or given voltage such as Vcc (VDD), left floating, or subject to a combination/sequence of these states.

In a preferred embodiment, having multiple sensor channels each operating according to the methodology described above for example in connection with Figures 7 and 8, the state of the sensor channels is controlled in a way that enables the circuitry to distinguish between crosstalk effects, for example due to conductive objects (e.g. a liquid film such as a water film) close to multiple electrodes, and an intentional touch by a human finger or other pointing body.

As described above in connection with Figure 7, the measurement process for each channel starts with connecting the sensor electrode (the terminal 40) to a known voltage source (usually Vcc) and thereby precharging the external capacitance 30 to this voltage. In the next state, the sensor electrode (the terminal 40) is disconnected from the voltage source and the acquisition process (taking of samples) starts. After all of the samples of the resultant discharge cycle have been taken, the process can re-start immediately or after a certain interval.

In a preferred multi-channel implementation of the described method, groups of channels (e.g. channels A, B and C) or all sensor channels are pre-charged at the same time, independently of which channel will be measured. Since the pre-charge cycle is synchronously applied to all electrodes, both sides of the coupling capacitances between adjacent electrode pairs (e.g. capacitances $C_{AB}$ and $C_{BC}$) are at the same electrical potential (voltage), so that the coupling capacitance in effect is not charged. In contrast to this, the capacitance of every single electrode against e.g. ground (GND) is charged to the known voltage, and therefore a change in this capacitance (e.g. introduced by a finger touch, i.e. a change in capacitance $C_F$) can be measured as described above.

After the time given for pre-charge, the channel to be measured is disconnected from the voltage source as described above, while all channels except the one to be measured are actively driven low (by switching the GPIO to output low in the case of an MCU implementation) at the same time (or almost the same time). This behaviour is shown in each of Figures 12(a), (b) and (c).

The capacitive coupling between the electrodes (e.g. capacitances $C_{AB}$ and $C_{BC}$) causes the negative slope (the voltage on the remaining electrodes becomes nearly zero in a short time, resembling a square wave, whereas the voltage on the electrode being measured follows an nearly exponential discharge curve) on the remaining electrodes to be coupled to the electrode being measured, introducing a (smaller) negative slope also in the voltage on this electrode.

Thus, in the context of Figure 12(a), negative slopes 202 and 204 for channels A and C couple via capacitances $C_{AB}$ and $C_{BC}$ to affect slope 206, making the values sampled for slope 206 smaller than they would have been if coupling capacitances $C_{AB}$ and $C_{BC}$ were not present.

Therefore, an increase in crosstalk causes the raw values of the acquisition to decrease, whereas an approaching object/finger touching mainly one electrode as in Figure 12(b) causes an increase in the raw values for the channel concerned as it is not, or is only merely, affected by the negative slope of the surrounding electrodes. This is represented in Figure 12(b) by slope 208 which would lead to larger sampled values as compared to those obtained for slope 206.

Since the influence of the cross-coupling between electrode pairs is symmetrical (in the absence of localised influences), an increase of crosstalk between different channels will cause a decrease of raw values for all affected channels, so that it can be detected by methods of signal processing and calibration to determine which channels are affected, and take corrective measures.

This is of interest in case some object or liquid 201 (such as water) is placed on the surface over the sensor electrodes, as in Figure 12(c), since it is desirable to avoid malfunction or false touch triggers. In Figure 12 (c), the presence of liquid 201 increases the coupling (capacitances $C_{AB}$) between channels A and B, but not between channels B and C. Thus, the value-reducing effect of the coupling discussed above in respect of Figure 12(a) is uneven in Figure 12(c) due to the present of liquid 201.

Thus, a sensing surface holding several sensing channels according to this preferred embodiment can be configured (by way of the sampling circuitry) in a way that it does not generate a touch output when a conductive object or liquid is placed on it, which gives a high amount of additional security against un-intentional operation of any equipment controlled by the touch sensor circuit.

It will be appreciated that the embodiments discussed above and depicted in the accompanying drawings mainly concern "discharging" arrangements in which the external capacitance is first pre-charged (for example, by connecting it to an internally available voltage source such as VDD) and then discharged by way of the sampling means. Whilst such "discharging" arrangements may be considered preferable for practical reasons, it will be understood that other embodiments may concern "charging" arrangements in which the external capacitance is first discharged (for example, by connecting it to an internally available voltage source such as GND) and then charged by way of the sampling means.

One of the benefits of the disclosed "discharging" arrangements is the utilisation of parasitic elements which cause a leakage current (usually against GND) to discharge the external capacitance, so for example the sampling elements present in a previously-considered or standard MCU may be used. In the case of "charging" arrangements, the sampling means may need to be modified (as compared to the sampling elements present in a previously-considered or standard MCU, or as compared to those shown in Figure 7). In particular, the sampling means may need to be modified such that the sampling capacitor (see the sampler capacitance 54 of Figure 7) is internally charged for example to Vcc (VDD) between two samples (while the sample switch - see the switching means 60 of Figure 7 - is open), so that during the 'burst' sampling every sample increases the voltage on the (initially discharged) external capacitance by a small amount.

Thus, embodiments of the present invention extend to such "charging" arrangements, but in some instances the "discharging" arrangements may be considered to be preferable for practical reasons (for example, making use of components provided in a previously-considered MCU, such as its ADC).

In one example implementation of such "charging" arrangements, a 'dummy sample' may be taken from a terminal other than the one being measured (i.e. other than from the terminal from which samples are to be taken) which is connected to Vcc (VDD), and then a switch may be made over to the electrode to be measured without discharging the sampling capacitor (see the sampler capacitance 54 of Figure 7) in between. However, due to leakage etc., a small amount of discharge may be expected during the switch over.

Accordingly, although in the "discharging" arrangements disclosed herein the 'parasitics' may be seen as beneficial, in "charging" arrangements the sampling capacitor may need to be actively re-charged between two samples. Thus, such "charging" arrangements may need to be configured to enable the sampling means to carry out such active re-charging, or for example there may need to be an additional step between samples in which a 'dummy' sample is taken from Vcc (VDD), since there would be no equivalent for the 'parasitic discharge' of the sampling capacitor that is taken advantage of in the "discharging" arrangements.

Embodiments of the present invention are considered advantageous for the following reasons at least:

- no external components required for capacitive touch sensing, external to the touch input pins (terminals);

  o the external capacitance present at such a pin may be present merely by way of presence of a sensing electrode connected to that pin;
  o such embodiments may provide a relatively low BOM (bill of materials) cost, and require a relative low amount of PCB space;

- in the Figure 7 embodiment, only a single terminal 40 is required per electrode 32;

  o with microcontrollers in mind, any ADC pin may be used as touch input when shared with GPIO functionality;

- increased noise immunity and SNR due to burst sampling and integration (summing) of the sampling values;

  o summing multiple samples (sampling values) of the discharge process averages noise spikes/bursts;
o a sum of raw sample values corresponds to the area under the discharge curve, resulting in a better response to small changes of discharge curve;
o increased dynamic range/headroom of the system;
o increased robustness against noise due to a lower virtual 'average' input impedance over the discharge cycle;

- in the case of burst sampling ("Continuous Mode"), multiple samples may be taken for each discharge process without re-initializing (discharge, precharge or similar);

  o faster over-sampling (with "Continuous Mode", the full ADC sample rate may be employed, with no re-initialisation between samples), leading to shorter times for touch acquisition/recognition;
  o noise filtering and sensitivity increase already on raw data level;

- no special peripherals (e.g. current source or high-resolution timer) required;

  o no accurate time measurement required - the methodology is relatively unaffected by jitter;
  o ADC continuous mode can be used - with no need to trigger every single sample - with the system thus being less sensitive for timing variances due to CPU (processor) load;
  o where DMA is used, IRQ (interrupt request) load can be reduced but for the price of one slightly longer calculation after sampling;

- low EMI (electromagnetic interference), high EMI robustness / tolerance;

  o no high-frequency signal required, leading to low EMI emissions from the sensing lines (terminals and sensing electrodes);

- easily adaptable to different measurement topologies;

  o a mix of self/mutual-capacitance sensing without hardware changes is possible in some embodiments, for example combining the teachings of Figures 6 and 11. Some embodiments may be configured to switching between self- and mutual-capacitance sensing during use, and combine inputs taken from both. In such a way, the advantages of both types of sensing may be enjoyed together;

- no influence of supply voltage on sensitivity;

o the reference voltage employed by the sampling means (ADC) may be the same as the precharge voltage applied to the terminal, i.e. the internal supply voltage (Vdd or Vcc) of the sampling circuitry;

- very low processor (e.g. CPU) load;

o can be further reduced by peripherals such as range comparators and pulse detection units and/or the use of DMA transfers.

The following statements are provided:

A1. A capacitive sensing method evaluating the voltage during discharge of a capacitance to be measured.

A2. A capacitive sensing method according to statement A1, wherein the internal capacitances and leakage currents of an ADC are used to discharge the capacitance to be measured.

A3. A capacitive sensing method according to statement A2, wherein the input voltage is sampled a plurality of times without re-initialization (pre-charge, discharge or similar) of the input capacitance, i.e. measuring a single discharge event at multiple points in time.

A4. A capacitive sensing method according to statement A3, wherein the data acquired by the multiple samples of a single discharge event are summed to form a value corresponding to the area under the discharge curve (time - voltage curve of the discharge process).

A5. A capacitive sensing method according to statement A4, wherein additional components such as resistors or current sinks are used (as additional components, for additional capabilities) to discharge the capacitance to be measured.

A6. A capacitive sensing method according to any of statements A1 to A5, wherein the capacitance to be measured is pre-charged to the same voltage as the ADC reference voltage before sampling.

A7. A capacitive sensing method according to any of statements A1 to A6, wherein the evaluation of the discharge curve of the capacitance to be measured is performed by comparing the raw sample values against an upper and lower threshold value and evaluating the results of the comparison.

A8. A capacitive sensing method according to statement A7, wherein the evaluation of the comparison result is done by incrementing, decrementing or resetting counters depending on the comparison results. For example, a pulse detection unit as discussed above may employ a number of counters to count events of the range comparator (in range, out of range, etc.). These counters may interact with one another, so that for example the occurrence of a certain event can re-set one counter, or increment another counter, etc..

A9. A capacitive sensing method using a first and a second filter with a first and a second set of parameters, wherein the first filter is fed with the raw measurement data, while the second filter is fed with either the output of the first filter or the raw measurement data, and wherein the difference between the outputs of these two filters is measured to generate touch strength information.

A10. A capacitive sensing method according to statement A9, wherein the filter parameters of one or both filters are dynamically adapted depending on other parameters such as touched/non-touched condition or the direction or speed of change of the raw values.

A11. A capacitive sensing method in which every connection to an external electrode of a touch sensitive area can be configured to operate as bidirectional electrode for self capacitance measurement, as sending electrode for mutual capacitance measurement, and as sensing electrode for mutual capacitance measurement during operation.

A12. A capacitive sensing method according to statement A11, in which the electrodes can be re-configured so that the system can be dynamically re-configured between self- and mutual capacitance measurement during operation.

A13. A capacitive sensing system in which the sensor electrodes are periodically checked for short-circuits to GND, other sensing electrodes or the supply voltage, as well as disconnection from the sensor pad to detect erroneous connections.

A14. A capacitive sensing system having improved SNR performance due to increased dynamic range/ headroom and due to a lower virtual 'average' input impedance over the discharge cycle.

A15. A capacitive sensing system having multiple sensing channels and being configured to pre-charge and then discharge a to-be-measured channel (electrode) in synchronisation with connecting the other channels (electrodes) to system voltage high (e.g. VDD) and then to system voltage low (e.g. GND), so as to take advantage of cross-coupling between the channels to distinguish between a touch and a substance such as water covering some channels (electrodes).

In any of the above aspects, the various features may be implemented in hardware, or as software modules running on one or more processors. Features of one aspect may be applied to any of the other aspects.
The invention also provides a computer program or a computer program product for carrying out any of the methods described herein, and a computer readable medium having stored thereon a program for carrying out any of the methods described herein. A computer program embodying the invention may be stored on a computer-readable medium, or it could, for example, be in the form of a signal such as a downloadable data signal provided from an Internet website, or it could be in any other form.

**Claims**

1. Integrated circuitry, comprising:

   a sampling terminal for connecting the integrated circuitry to an external capacitance;
   sampling means operatively connected to the terminal to take samples, each sample having a sample value; and
   control means configured, whilst said external capacitance is connected to the sampling terminal, to:

      internally connect the sampling terminal, or another terminal of the integrated circuitry to which the external capacitance is also connected, to a given voltage-potential source to effect a change in charge stored on the external capacitance, the given voltage-potential source being available within the integrated circuitry when it is in use;
      cause the sampling means to take a plurality of samples over a period whilst that external capacitance charges or discharges following and/or during said change in charge; and
      judge whether an event has occurred in dependence upon the plurality of samples.

2. Integrated circuitry as claimed in claim 1, wherein the control means is configured, when said external capacitance is connected to the sampling terminal, to, in a first phase, connect the sampling terminal to said given voltage-potential source and, in a second phase following said first phase, disconnect the sampling terminal from the given voltage-potential source and to cause said samples to be taken.

3. Integrated circuitry as claimed in claim 1 or 2, wherein:

   said other terminal of the integrated circuitry is a signalling terminal;
   the control means is configured to carry out a signalling process and a sampling process when said external capacitance is connected between the sampling terminal and the signalling terminal; and
   the control means is configured, in the signalling process, to connect the signalling terminal to said given voltage-potential source as a signal and, in the sampling process, to cause said samples to be taken so as to detect said signal.

4. Integrated circuitry as claimed in any of the preceding claims, wherein the sampling means comprises a sampler resistance and a sampler capacitance arranged such that, when the sampling means is taking a sample and the external capacitance is present at the sampling terminal, charge stored on the external capacitance is permitted to transfer to the sampler capacitance via the sampler resistance.

5. Integrated circuitry as claimed in claim 4, configured such that, between taking successive said samples of the plurality of samples, the sampler capacitance is passively at least partly discharged by way of parasitic and/or leakage currents within the sampling circuitry, and/or actively at least partly discharged by connecting it to a given voltage-potential source such as a ground source.

6. Integrated circuitry as claimed in any of the preceding claims, configured, after taking a sample of said plurality of samples, to automatically take the next said sample of the plurality of samples, such that said samples are taken in a burst process.

7. Integrated circuitry as claimed in any of the preceding claims, wherein the control means is configured to combine the sample values of the plurality of samples to generate a sampling result, and to judge whether the event has occurred in dependence upon the sampling result.

8. Integrated circuitry as claimed claim 7, configured to obtain a series of said sampling results over time, each from a corresponding said plurality of sample values obtained over a corresponding period whilst the external capacitance charges or discharges, wherein the control means is configured to judge whether the event has occurred in dependence upon the series of sampling results.

9. Integrated circuitry as claimed in claim 8, comprising a filter configured to filter a signal formed from said sampling results to obtain a filtered signal.

10. Integrated circuitry as claimed in any of the preceding claims, wherein the control means is operable to detect a fault in said sampling circuitry based upon said sampling values and/or sampling results and corresponding information indicative of a fault condition.

11. Integrated circuitry as claimed in any of the preceding claims, comprising a plurality of said sampling terminals, wherein the control means is operable to cause a plurality of samples to be taken for each said sampling terminal.

12. Integrated circuitry as claimed in claim 11, wherein the control means is configured, in synchronisation with the said first phase for a particular one of those terminals, to connect the other said terminals to said given voltage-potential source and, in synchronisation with the said second phase for the particular terminal, to disconnect the other said terminals from the given voltage-potential source and to connect them to another voltage-potential source configured to have an opposite effect on the external capacitances of those other terminals to the effect had on them during the first phase of the particular said terminal.

13. A microcontroller comprising integrated circuitry as claimed in any of the preceding claims.

14. Apparatus for capacitive touch sensing, comprising:

integrated circuitry or a microcontroller as claimed in any of the preceding claims; and
a capacitance connected to the sampling terminal as said external capacitance and configured to be touchable by a user of the apparatus.

15. A computer program which, when executed on integrated circuitry comprising a sampling terminal for connecting the integrated circuitry to an external capacitance and sampling means operatively connected to the terminal to take samples each having a sample value, causes the integrated circuitry, whilst said external capacitance is connected to the sampling terminal, to:

internally connect the sampling terminal, or another terminal of the integrated circuitry to which the external capacitance is also connected, to a given voltage-potential source to effect a change in charge stored on the external capacitance, the given voltage-potential source being available within the integrated circuitry when it is in use;
cause the sampling means to take a plurality of samples over a period whilst that external capacitance charges or discharges following and/or during said change in charge; and
judge whether an event has occurred in dependence upon the plurality of samples.

**Amended claims in accordance with Rule 137(2) EPC.**

1. Integrated circuitry (2; 20; 120), comprising:

a sampling terminal (4; 40) for connecting the integrated circuitry to an external capacitance (3; 30);
sampling means (5; 50) operatively connected to the terminal (4; 40) to take samples, each sample having a sample value; and
control means (7; 70) configured, whilst said external capacitance (3; 30) is connected to the sampling terminal (4; 40), to:
internally connect the sampling terminal (4; 40), or another terminal (140) of the integrated circuitry to which the external capacitance (3; 30) is also connected, to a given voltage-potential source to effect a change in charge stored on the external capacitance (3; 30), the given voltage-potential source being available within the integrated circuitry (2; 20; 120) when it is in use;
cause the sampling means (5; 50) to take a plurality of samples over a single period whilst that external capacitance (3; 30) charges or discharges following and/or during said change in charge; and
judge whether an event has occurred in dependence upon the plurality of samples.

2. Integrated circuitry as claimed in claim 1, wherein the control means is configured, when said external capacitance (3; 30) is connected to the sampling terminal, to, in a first phase, connect the sampling terminal (4; 40) to said given voltage-potential source and, in a second phase following said first phase, disconnect the sampling terminal (4; 40) from the given voltage-potential source and to cause said samples to be taken.

3. Integrated circuitry as claimed in claim 1 or 2, wherein:

said other terminal of the integrated circuitry is a signalling terminal (140);
the control means (5) is configured to carry out a signalling process and a sampling process when said external capacitance is connected between the sampling terminal (4) and the signalling terminal (140); and
the control means (5) is configured, in the signalling process, to connect the signalling terminal (140) to said given voltage-potential source as a signal and, in the sampling process, to cause said samples to be taken so as to detect said signal.

**4.** Integrated circuitry as claimed in any of the preceding claims, wherein the sampling means (50) comprises a sampler resistance (56) and a sampler capacitance (54) arranged such that, when the sampling means (50) is taking a sample and the external capacitance (30) is present at the sampling terminal (40), charge stored on the external capacitance (30) is permitted to transfer to the sampler capacitance (54) via the sampler resistance (56).

**5.** Integrated circuitry as claimed in claim 4, configured such that, between taking successive said samples of the plurality of samples, the sampler capacitance (54) is passively at least partly discharged by way of parasitic and/or leakage currents within the sampling circuitry, and/or actively at least partly discharged by connecting it to a given voltage-potential source such as a ground source.

**6.** Integrated circuitry as claimed in any of the preceding claims, configured, after taking a sample of said plurality of samples, to automatically take the next said sample of the plurality of samples, such that said samples are taken in a burst process.

**7.** Integrated circuitry as claimed in any of the preceding claims, wherein the control means (7; 70) is configured to combine the sample values of the plurality of samples to generate a sampling result, and to judge whether the event has occurred in dependence upon the sampling result.

**8.** Integrated circuitry as claimed claim 7, configured to obtain a series of said sampling results over time, each from a corresponding said plurality of sample values obtained over a corresponding period whilst the external capacitance (3; 30) charges or discharges, wherein the control means (7; 70) is configured to judge whether the event has occurred in dependence upon the series of sampling results.

**9.** Integrated circuitry as claimed in claim 8, comprising a filter configured to filter a signal formed from said sampling results to obtain a filtered signal.

**10.** Integrated circuitry as claimed in any of the preceding claims, wherein the control means is operable to detect a fault in said sampling circuitry based upon said sampling values and/or sampling results and corresponding information indicative of a fault condition.

**11.** Integrated circuitry as claimed in any of the preceding claims, comprising a plurality of said sampling terminals (4; 40), wherein the control means is operable to cause a plurality of samples to be taken for each said sampling terminal (4; 40).

**12.** Integrated circuitry as claimed in claim 11, wherein the control means is configured, in synchronisation with the said first phase for a particular one of those terminals, to connect the other said terminals to said given voltage-potential source and, in synchronisation with the said second phase for the particular terminal, to disconnect the other said terminals from the given voltage-potential source and to connect them to another voltage-potential source configured to have an opposite effect on the external capacitances of those other terminals to the effect had on them during the first phase of the particular said terminal.

**13.** A microcontroller comprising integrated circuitry as claimed in any of the preceding claims.

**14.** Apparatus for capacitive touch sensing, comprising:

integrated circuitry or a microcontroller as claimed in any of the preceding claims; and a capacitance connected to the sampling terminal as said external capacitance and configured to be touchable by a user of the apparatus.

**15.** A computer program which, when executed on integrated circuitry (2; 20; 120) comprising a sampling terminal (4; 40) for connecting the integrated circuitry to an external capacitance (3; 30) and sampling means (5; 50) operatively connected to the terminal (4; 40) to take samples each having a sample value, causes the integrated circuitry (2; 20; 120), whilst said external capacitance (3; 30) is connected to the sampling terminal (4; 40), to:

internally connect the sampling terminal (4; 40), or another terminal (140) of the integrated circuitry to which the external capacitance (3; 30) is also connected, to a given voltage-potential source to effect a change in charge stored on the external capacitance (3; 30), the given voltage-potential source being available within the integrated circuitry when it is in use; cause the sampling means (5; 50) to take a plurality of samples over a single period whilst that external capacitance (3; 30) charges or discharges following and/or during said change in charge; and judge whether an event has occurred in dependence upon the plurality of samples.

**16.** A sampling method which, when carried out on integrated circuitry (2; 20; 120) comprising a sampling terminal (4; 40) for connecting the integrated circuitry (2; 20; 120) to an external capacitance (3; 30) and sampling means (5; 50) operatively connected to the terminal (4; 40) to take samples each having a sample value, causes the integrated circuitry (2; 20; 120), whilst the external capacitance (3; 30) is connected to the sampling terminal (4; 40), to:

internally connect the sampling terminal (4; 40), or another terminal (140) of the integrated circuitry to which the external capacitance (3; 30) is also connected, to a given voltage-potential source to effect a change in charge stored on the external capacitance (3; 30), the given voltage-potential source being available within the integrated circuitry (2; 20; 120) when it is in use; cause the sampling means (5; 50) to take a plurality of samples over a single period whilst that external capacitance (3; 30) charges or discharges following

FIG. 1

FIG. 2

FIG. 3

FIG. 4

FIG. 5

1

2

7

CONTROL MEANS

5

SAMPLING
MEANS

4

3

6

FIG. 6

FIG. 7

START

SET TERMINAL
TO OUTPUT HIGH — S2

DISCONNECT TERMINAL
FROM VOLTAGE SOURCE — S4

TAKE PLURALITY
OF SAMPLES — S6

JUDGE WHETHER EVENT
HAS OCCURED — S8

END

FIG. 8

FIG. 9

(a)

INPUT SIGNAL

FILTER
1

AVERAGED

FILTER
2

BASELINE

EP 2 464 008 A1

(b)

INPUT SIGNAL

FILTER
1

AVERAGED

FILTER
2

BASELINE

FIG. 10

100

120

7

CONTROL MEANS

5

4

3

6

SAMPLING
MEANS

SIGNALLING MEANS

140

160

FIG. 11

FIG. 12

## ANNEX TO THE EUROPEAN SEARCH REPORT
## ON EUROPEAN PATENT APPLICATION NO.

EP 10 19 4178

This annex lists the patent family members relating to the patent documents cited in the above-mentioned European search report.
The members are as contained in the European Patent Office EDP file on
The European Patent Office is in no way liable for these particulars which are merely given for the purpose of information.

07-07-2011

| Patent document cited in search report | | Publication date | Patent family member(s) | | Publication date |
|---|---|---|---|---|---|
| US 2010277351 | A1 | 04-11-2010 | JP<br>WO | 2011507410 A<br>2009076604 A1 | 03-03-2011<br>18-06-2009 |
| EP 2230765 | A1 | 22-09-2010 | NONE | | |
| US 2007176609 | A1 | 02-08-2007 | NONE | | |
| US 4728932 | A | 01-03-1988 | NONE | | |
| US 2010181180 | A1 | 22-07-2010 | WO | 2010083123 A1 | 22-07-2010 |

EPO FORM P0459

**EP 2 464 008 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6466036 B